Europäisches Patentamt

European Patent Office

Office européen des brevets

(11) Publication number: **0 315 057**
**A2**

## (12) EUROPEAN PATENT APPLICATION

(21) Application number: 88117913.9

(51) Int. Cl.4: **H05K 7/14 , H02B 1/04**

(22) Date of filing: 27.10.88

(30) Priority: 03.11.87 IT 2264987 U

(43) Date of publication of application:
10.05.89 Bulletin 89/19

(84) Designated Contracting States:
DE ES FR GB

(71) Applicant: Montaguti, Giovanni
Via Savona 69/a
I-29144 Milano(IT)

(72) Inventor: Montaguti, Giovanni
Via Savona 69/a
I-29144 Milano(IT)

(74) Representative: Modiano, Guido et al
MODIANO, JOSIF, PISANTY & STAUB
Modiano & Associati Via Meravigli, 16
I-20123 Milan(IT)

(54) Modular support element structure particularly for circuit boards.

(57) The modular support element structure (1) comprises a central portion (2) having lateral wings (10) defining seats (11,12) for accommodating circuit boards of different widths, members (3) for coupling the support element (1) to standardized support bars, and male and female couplings (25), for laterally interconnecting a plurality of modular support elements (1) to define a circuit board support tray. End walls can be connected to the outer ends of such interconnected modular elements to close the support tray defined thereby.

FIG. 1

## MODULAR SUPPORT ELEMENT STRUCTURE, PARTICULARLY FOR CIRCUIT BOARDS

The present invention relates to a modular support element structure particularly for circuit boards.

As known, circuit boards are used in many devices in the field of electronics, such as computerized devices, industrial systems, display systems, measuring devices, data processing centers, logic programmers and the like; such circuit boards are substantially constituted by a plate-like element made of electrically insulating material, and the various electronic components, such as transistors, diodes, transformers, capacitors, terminal strips, contacts and the like are connected to said circuit board; the electric circuits are also printed thereon.

Circuit boards having different widths with respect to one another are currently commercially available, such as e.g. the so-called "EUROPA" boards, standardized according to DIN, UNI and CENELEC norms, and the so-called "AMERICA" boards, which are standardized according to other norms.

The boards must be arranged on a horizontal or vertical plane and have, for this purpose, standardized bars to which the boards are connected by means of support elements, which are mutually joined so as to form a support which is commonly termed "tray".

The support element has means to removably couple with the support bars on one side and a seat which engages with the edges of said boards on the other side.

The presence of boards having different widths forces to use support element which consequently have different widths; in many cases this means that when the board must be changed it is also necessary to change the support element to adapt to the new width of the board.

This fact obviously causes considerable disadvantages because it is necessary to replace a plurality of elements and because it is necessary to have available support elements which define seats with different widths.

The aim of the present invention is indeed to eliminate the disadvantages described above by providing a modular support element for circuit boards which can accommodate boards of different widths without thereby having to perform replacements or modifications on said support element.

Within the scope of the above described aim, a particular object of the invention is to provide a modular element which is practical and versatile in use and can be arranged adjacent with other identical support elements, so as to obtain the required length, according to the length of the board.

Still another object of the present invention is to provide a modular element structure which by virtue of its peculiar constructive characteristics is capable of giving the greatest assurances of reliability and safety in use.

Not least object of the present invention is to provide a modular element structure which is easily obtainable starting from elements and material commonly commercially available and which is furthermore competitive from a merely economical point of view.

The above described aim, as well as the objects mentioned and others which will become apparent hereinafter, are achieved by a modular support element structure particularly for circuit boards, according to the invention, comprising a modular body which has means for removably coupling with a support bar on one side, characterized in that it comprises, on the other side, a pair of opposite wings which define at least two seats to support boards having different widths.

Further characteristics and advantages of the invention will become apparent from the detailed description of a modular support element structure particularly for circuit boards, illustrated only by way of non-limitative example in the accompanying drawings, wherein:

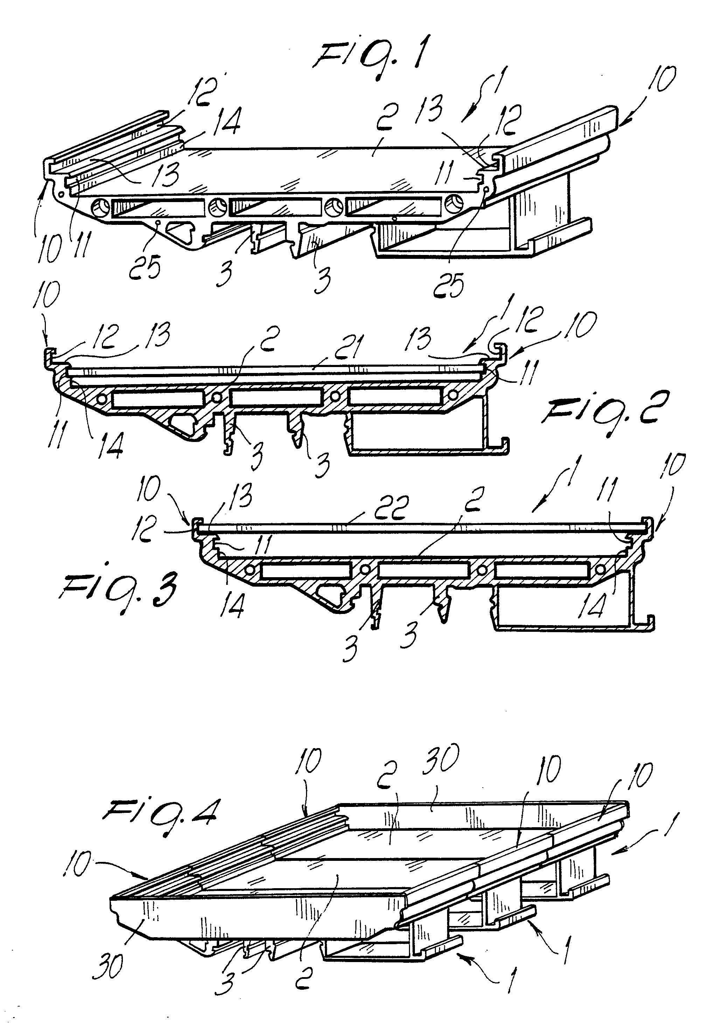

figure 1 is a schematic perspective view of the modular support element structure according to the invention;

figure 2 is a sectional view of the modular support element with a board applied in one of the seats:

figure 3 is a sectional view of the modular support element structure with a board applied in the other seat:

figure 4 is a schematic view of a tray obtainable by arranging a plurality of modular elements side by side.

With reference to the above described figures, the modular support element structure particularly for circuit boards, according to the invention, comprises a modular body, generally indicated by the reference numeral 1, which defines a substantially planar central portion 2 which has, at its lower face, means of a per se known type, generally indicated by the reference numeral 3, which can couple with the standardized support bars which are normally in the shape of a C, of an $\Omega$ or of a micro$\Omega$.

The important peculiarity of the invention resides in the fact that mutually opposite lateral wings 10 are provided at the lateral ends of the portion 2 on the opposite side with respect to the face bearing the coupling means 3; said wings define, in the described embodiment, a first seat 11 and a second seat 12.

The seats 11 and 12 are arranged so as to be engageable with boards having different widths: more specifically, for example that the seats 11 may be engageable with the edges of boards 21 having a width of 100 mm, while the seats 12 may allow coupling with boards 22 having a width of 108 mm.

In the practical embodiment, the seat 12 defines a lower support edge 13 which in practice overlies the seat 11 which is provided on the inner edge of the wing 10 and is spaced by a distance 14 from the planar portion.

The various modular bodies 1 are manufactured so that they can be arranged side by side with respect to one another, so as to provide a support tray of the required dimensions.

For this purpose the modular body 1 defines, on the edges not affected by the wings 10, respectively male and female couplings indicated by the reference numeral 25 which allow the mutual coupling of adjacent modular bodies.

The modular bodies preferably have a width of approximately 40 mm, since this is the submultiple which allows coupling with the boards normally used, which generally have a length which is a multiple of 40 mm; modular bodies having different lengths may however be also provided according to contingent requirements.

As schematically shown in figure 4, the support tray is completed by end walls indicated by the reference numeral 30 which in practice close the longitudinal ends of a plurality of adjacent modular bodies.

From the above it can thus be seen that the invention achieves the intended aim and objects, and in particular the fact is stressed that the provision of a modular body with a pair of opposite wings which define two seats to support boards of different widths allows to replace the boards even with boards of different width without thereby having to remove the support bodies. It is also advantageously possible to standardize the support bodies, providing one which can be used with the normally most common boards.

It should be furthermore added that the number of seats provided on the wings can be greater and also have different dimensions, for accommodating a wide range of boards possibly commercially available.

In practice, the materials employed, as well as the contingent shapes and dimensions, may be any according to the requirements.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. Modular support element structure particularly for circuit boards comprising a modular body (1) having, on one face thereof, means (3) for removably coupling with a support bar, characterized in that it comprises, on its other face, a pair of opposite wings (10) which define at least two seats (11,12) for supporting circuit boards of different widths.

2. Modular support element structure, particularly for circuit boards, according to claim 1, characterized in that said at least two seats (11,12) are arranged at different levels.

3. Modular support element structure, particularly for circuit boards, according to claim 1, characterized in that said modular body (1) defines a planar central portion (2) and in that said seats (11,12) overlie said planar central portion (2).

4. Modular support element structure, particularly for circuit boards, according to one or more of the preceding claims, characterized in that the lower edge (13) of the second seat (12) of said seats (11,12) overlies the region in which the first of said seats (11) is defined.

5. Modular support element structure, particularly for circuit boards, according to claim 1, characterized in that said modular body (1) has, on its edges not affected by said wings (10), means (25) for mutually coupling modular support elements (1) arranged side by side.

6. Modular support element structure, according to claim 5, characterized in that it comprises at least one closure wall (30) associable with the longitudinal ends of said modular bodies (1) arranged side by side.

Fig. 1

Fig. 2

Fig. 3

Fig. 4